Europäisches Patentamt

European Patent Office

Office européen des brevets

(19)

(11) **EP 0 505 619 B1**

(12) **EUROPÄISCHE PATENTSCHRIFT**

(45) Veröffentlichungstag und Bekanntmachung des Hinweises auf die Patenterteilung:
**09.09.1998** **Patentblatt 1998/37**

(51) Int Cl.$^6$: **G01R 33/04**

(21) Anmeldenummer: **91121011.0**

(22) Anmeldetag: **07.12.1991**

(54) **Anordnung zur Detektion des Vorhandenseins und/oder zur Ermittlung der Gestalt auch geringer Quantitäten einer magnetischen Substanz**

Device for the detection of the presence and/or determination of the appearance even of small quantities of a magnetic substance

Dispositif de détection de la présence et/ou la détermination de l'apparence, même en quantités faibles d'une substance magnétique

(84) Benannte Vertragsstaaten:
**CH DE DK ES FR GB IT LI NL SE**

(30) Priorität: **26.03.1991 CH 928/91**

(43) Veröffentlichungstag der Anmeldung:
**30.09.1992 Patentblatt 1992/40**

(73) Patentinhaber: **MARS INCORPORATED**
**McLean Virginia 22101-3885 (US)**

(72) Erfinder: **Seitz, Thomas**
**CH-6300 Zug (CH)**

(74) Vertreter: **Burke, Steven David et al**
**R.G.C. Jenkins & Co.**
**26 Caxton Street**
**London SW1H 0RJ (GB)**

(56) Entgegenhaltungen:
**DE-A- 3 738 455**     **US-A- 3 643 155**
**US-A- 3 829 894**

## Beschreibung

Die Erfindung bezieht sich auf eine Vorrichtung zum Nachweis einer magnetischen Substanz gemäss dem Oberbegriff des Anspruchs 1, insbesondere zur Detektion des Vorhandenseins und/oder zur Ermittlung der Gestalt auch geringer Quantitäten der magnetischen Substanz.

Die in geringen Quantitäten vorhandene magnetische Substanz ist vorzugsweise magnetische Tinte oder ein paramagnetisches Gas, wie z. B. Sauerstoff. Im ersteren Fall kann die Anordnung z. B. in einem Banknotenerkennungsautomat eingesetzt werden zur Detektion und/oder zum Lesen eines mittels magnetischer Tinte ausgeführten Schriftbildes auf einer z. B. US-, JP- oder DE-Banknote. Im zweiten Fall kann die Anordnung verwendet werden z. B. in einem Gasanalysator zur Detektion des Vorhandenseins eines paramagnetischen Gases. Die Anordnung kann auch verwendet werden zur Messung der Drehzahl eines Zahnrades, welches aus magnetischem Material besteht oder dessen Zähne sowie Zahnlücken mindestens mit einem magnetischen Material bedeckt sind.

Aus der US-PS 4 864 238 ist eine Anordnung der im Oberbegriff des Anspruchs 1 genannten Art bekannt zum Messen flussarmer Magnetfelder, wie sie z. B. von auf Banknoten vorhandener magnetisierter magnetischer Tinte erzeugt werden. Zu diesem Zweck ist dort ein nach dem Kernsaturations-Prinzip arbeitender, äusserst empfindlicher Sensor vorhanden, der die extrem schwachen, von der magnetisierten magnetischen Tinte der Banknote herrührenden Magnetfelder misst, die einen Wert in der Grössenordnung von $10^{-7}$ Tesla ($10^{-3}$ Gauss) aufweisen. Da schon die Erdmagnetfeldstärke mit $5 \times 10^{-5}$ Tesla (0,5 Gauss) um zirka drei Grössenordnungen grösser ist, bedarf dabei der erwähnte Sensor zur Erfüllung seiner Aufgabe einer aufwendigen und teuren magnetischen Abschirmung. Ausserdem muss die Banknote vor dem Lesen mittels eines starken Permanentmagneten magnetisiert werden.

Der Erfindung liegt die Aufgabe zugrunde, die bekannte Anordnung so abzuändern, dass kein Permanentmagnet zum Magnetisieren der magnetischen Substanz sowie keine teure und aufwendige magnetische Abschirmung gegen Fremdmagnetfelder mehr erforderlich ist und dass mindestens bei der Detektion des Vorhandenseins der magnetischen Substanz eine statische Messung möglich ist, die ohne relative Bewegung zwischen magnetischer Substanz und Sensor den grössten Teil des Gesamtbildes der magnetischen Substanz, also z. B. den grössten Teil eines Schriftbildes auf einer Banknote, erfasst, wodurch u. a. eine erhöhte Sicherheit gegen Missbrauch erzielt wird.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen.

Ausführungsbeispiele der Erfindung sind in der Zeichnung dargestellt und werden im folgenden näher beschrieben. Es zeigen:

Fig. 1     eine schematisches elektrisches Schaltbild einer erfindungsgemässen Anordnung,
Fig. 2     einen kennlinienmässige Darstellung des Kernsaturations-Prinzips,
Fig. 3     einen Querschnitt eines Sensors mit Banknote,
Fig. 4     eine Draufsicht des in der Fig. 3 dargestellten Sensors ohne Banknote und
Fig. 5     eine Draufsicht einer weiteren Kernvariante.

Gleiche Bezugszahlen bezeichnen in allen Figuren der Zeichnung gleiche Teile.

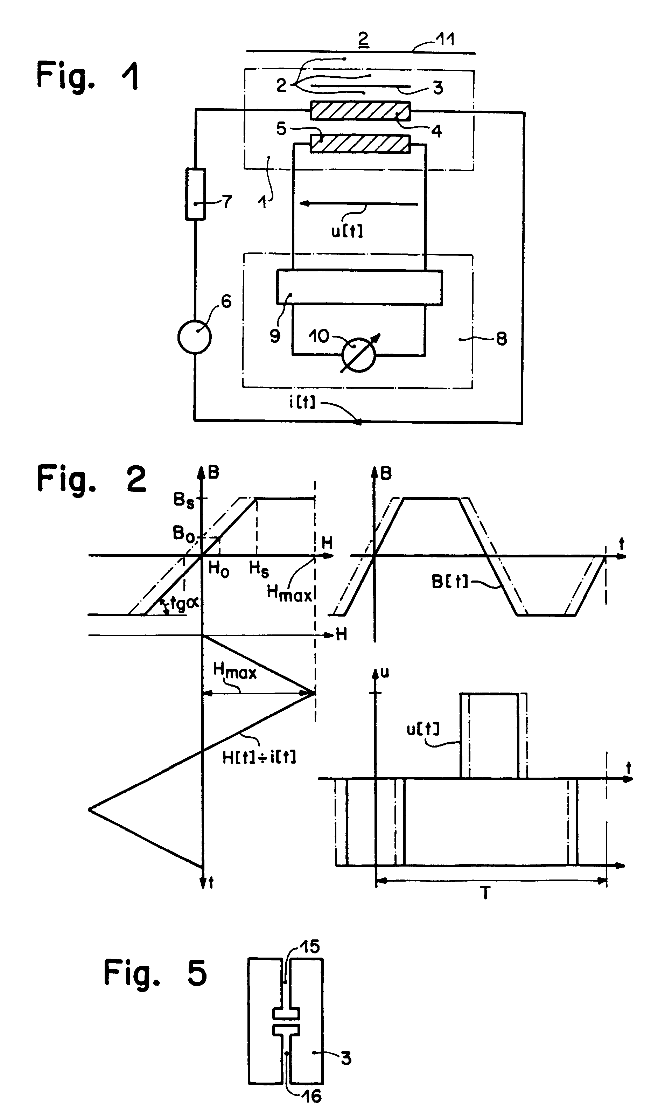

Die in der Fig. 1 dargestellte Anordnung enthält einen Sensor 1, der einen, mindestens einen Luftspalt 2 und einen ferromagnetischen Kern 3 aufweisenden Magnetkreis 2;3 sowie mindestens zwei Spulen 4 und 5 aufweist. Die beiden Spulen 4 und 5 sind induktiv miteinander gekoppelt und auf einer gleichen, in der Darstellung der Zeichnung unteren Seite des Kerns 3 angeordnet. Ein Generator 6 speist eine erste Spule 4 der beiden Spulen 4 und 5 über einen Vorwiderstand 7 mit mindestens einem zeitlich periodisch variablen Erregerstrom i[t] der Periode T. Der zeitlich variable Erregerstrom i[t] ist vorzugsweise in Funktion der Zeit t ein sägezahnförmiger Erregerstrom, er kann aber auch z. B. ein sinusförmiger Erregerstrom sein. Ein sägezahnförmiger Erregerstrom i[t] und damit eine sägezahnförmige Erregung des Kerns 3 erzeugt bei gleicher Aussteuerung weniger Verluste als ein sinusförmiger Erregerstrom i[t]. Die zweite Spule 5 der beiden Spulen 4 und 5 stellt eine Messspule dar, deren beide Pole einen zweipoligen Ausgang des Sensors 1 bilden, an dem im Betrieb eine Ausgangsspannung u[t] ansteht. In der in der Fig. 1 dargestellten Anordnung ist ausserdem eine Anordnung 8 vorhanden zur Auswertung des Wertes einer Oberwelle der Ausgangspannung u[t] des Sensors 1. Der Ausgang des Sensors 1 ist auf einen Eingang der Anordnung 8 geführt, die in der angegebenen Reihenfolge z. B. aus einer Kaskadenschaltung eines Bandpassverstärkers 9 und eines Voltmeters 10 besteht, wobei der Bandpassverstärker 9 die betreffende auszuwertende Oberwelle aus dem Frequenzspektrum der Ausgangsspannung u[t] herausfiltert und verstärkt. Das Voltmeter 10 ist ein Wechselspannungsvoltmeter und misst z. B. den Effektivwert der Ausgangsspannung des Bandpassverstärkers 9, d. h. der herausgefilterten verstärkten Oberwelle. In der Fig. 1 wurde angenommen, dass die magnetische Substanz magnetische Tinte ist, mit der eine Banknote 11 bedruckt ist. Die letztere und damit auch die magnetische Substanz befindet sich anlässlich ihrer Auswertung mindestens zeitweise in der Nähe des Kerns 3 innerhalb des Luftspaltes 2 und zwar auf der von den beiden Spulen 4 und 5 abgewandten Seite des Kerns 3. Falls der Kern 3, wie in der Fig. 1 angenommen, ein flacher Kern ist, dann ist die Banknote 11 während der Auswertung in einem Abstand bis zu zirka 1 mm parallel zum Kern 3 angeordnet.

Der Sensor 1 arbeitet nach dem Kernsaturations-Prinzip. Da letzteres an sich bekannt und u. a. im oben angegebenen Stand der Technik beschrieben ist, wird es nur zum besseren Verständnis der Erfindung nachfolgend anhand der Fig. 2 kurz beschrieben.

In der Fig. 2 ist oben links eine idealisierte Kennlinie B[H] der effektiven Induktion B des Magnetkreises 2;3 in Funktion des vom Erregerstrom i[t] erzeugten Erregermagnetfeldes H[t] dargestellt, wobei die Hysteresis des ferromagnetischen Kerns 3 vernachlässigt und die Kennlinie ausserhalb der Sättigung als linear angenommen wurde. $B_s$ bezeichnet in der Fig. 2 die Sättigungsinduktion, die einem Sättigungsmagnetfeld $H_s$ entspricht. Unten links in der Fig. 2 ist in Funktion der Zeit t das den Magnetkreis 2;3 erregende Erregermagnetfeld H[t] dargestellt, welches proportional durch den Erregerstrom i[t] mit Hilfe der Spule 4 erzeugt wird. In der Fig. 2 gilt die Annahme, dass der Erregerstrom i[t] und damit auch das Erregermagnetfeld H[t] in Funktion der Zeit t sägezahnförmig sind. Die Amplitude $H_{max}$ des sägezahnförmigen Erregermagnetfeldes H[t] ist so gross gewählt, dass der ferromagnetische Kern 3 periodisch in die Sättigung gesteuert wird. Dadurch erhält die im Magnetkreis 2;3 vorhandene magnetische Induktion B[t] in Funktion der Zeit t einen periodisch trapezförmigen Verlauf, welcher in der Fig. 2 oben rechts dargestellt ist. Die Flanken des trapezförmigen Verlaufs erzeugen durch magnetische Induktion in die Messspule 5 die periodische Spannung u[t] der Periode T, deren zeitlicher Verlauf aus einer Reihe abwechselnd positiver und negativer rechteckförmiger Spannungsimpulse besteht.

Durch Einwirken eines äusseren Magnetfeldes $H_o$, dem eine magnetische Induktion $B_o$ entspricht, entstehen die in der Fig. 2 strichpunktiert dargestellten Kennlinien. Insbesondere erhalten die rechteckförmigen Spannungsimpulse der Ausgangsspannung u[t] in Richtung der Zeitachse eine Asymmetrie, deren Wert zum Messen des Wertes des äusseren Magnetfeldes $H_o$ ausgenutzt werden kann. In jedem Fall besteht die periodische Ausgangsspannung u[t] gemäss einer Fourier-Analyse aus einer, mit einer laufenden Nummer Eins versehenen Grundwelle und einer Vielzahl, bei zwei beginnend, fortlaufend durchnummerierten Oberwellen. Die laufende Nummer der Grundwelle und der Oberwellen wird nachfolgend mit n bezeichnet. In der in der US-PS 4 864 238 beschriebenen Anordnung ist das äussere Magnetfeld $H_o$ das Magnetfeld der magnetisierten magnetischen Tinte und zur Ermittlung von dessen Wert wird dort der Wert der zweiten Oberwelle der Ausgangsspannung u[t] ausgewertet.

Gemäss der Fourier-Analyse ist die Amplitude der n-ten Oberwelle gleich:

$$U_n = [(16H_{max})/(n.\pi.H_s)]\mu_o.\mu_r{}^*.n_2.f_1.F.H_s.$$

$$\sin[(n.\pi.H_s)/(2H_{max})].\sin[(n.\pi/2)(1+H_o/H_{max})] \qquad (1)$$

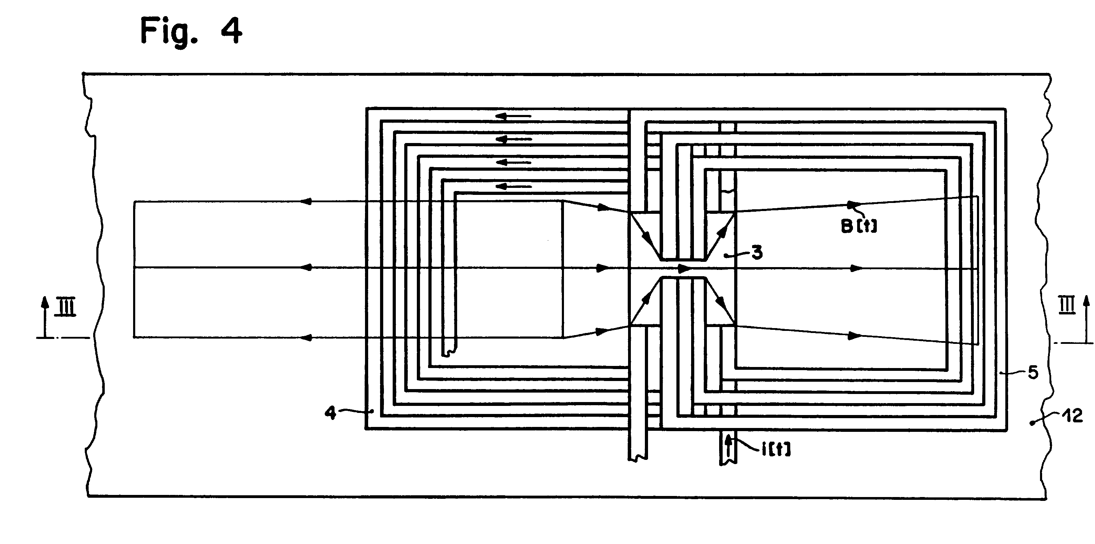

Dabei ist $\mu_o$ die Permeabilität des Vakuums, $\mu_r{}^*$ die effektive relative Permeabilität ("appearing permeability") des Magnetkreises 2;3 und damit die Neigung $tg\alpha$ der Sensorkennlinie B(H) ausserhalb des Sättigungsbereichs (siehe Fig. 2), $n_2$ die Windungszahl der Messspule 5, $f_1$ die Frequenz der Grundwelle des Erregerstromes i[t] und damit der Grundwelle der Ausgangsspannung u[t], F die Fläche des Querschnittes des Kerns 3 und $H_{max}$ die Amplitude des Erregermagnetfeldes H[t]. Bei einem H-förmigen ferromagnetischen Kern 3 (siehe Fig. 4), der aus zwei relativ breiten Hauptstegen und einem schmalen länglichen Quersteg besteht, ist F die Fläche des senkrecht zur Längsachse verlaufenden Querschnittes des Querstegs. Die effektive relative Permeabilität $\mu_r*$ des Magnetkreises 2;3 ist bekanntlich gleich $1/[N + (1/\mu_r)]$, wobei N der sogenannte Entmagnetisierungsfaktor und $\mu_r$ die relative Permeabilität des ferromagnetischen Materials des Kerns 3 ist.

Wenn der Sensor 1 einem periodischen zeitvariablen Erregermagnetfeld H[t] ausgesetzt ist, dessen Amplitude $H_{max}$ grösser als das Sättigungsmagnetfeld $H_s$ des Magnetkreises 2;3 ist, und wenn die Amplitude $H_{max}$ ein geradzahliges Vielfaches $2k.H_{max}$ besitzt, welches gleich einem n-fachen Wert des Sättigungsmagnetfeldes $H_s$ des Magnetkreises 2;3 ist, dann ist einerseits der Kern 3 zeitweise in der Sättigung sowie anderseits der erste Sinusfaktor in der Gleichung (1) und damit auch die Amplitude $U_n$ der Oberwelle gleich Null trotz vorhandenem äusseren Magnetfeld $H_o$. Der Faktor k besitzt dabei einen beliebigen ganzzahligen Wert.

Erscheint jetzt in der Nähe des Sensors 1, d. h. im Luftspalt 2, magnetisches Material, wie z. B. magnetische Tinte, dann wird der Sensor 1 verstimmt, da der Entmagnetisierungsfaktor N und damit auch die Neigung der gescherten Kennlinie B[H] sich beim Annähern der magnetischen Substanz ändern, was zu einem andern Wert der Sättigungsmagnetfeldes $H_s$ führt, so dass bei einem gegebenen Wert $H_{max}$ der Amplitude des Erregermagnetfeldes H[t] die Bedingung $2k.H_{max} = n.H_s$ für den Amplitudennullwert der betreffenden Oberwelle nicht mehr erfüllt ist. Das volle Spektrum der Oberwellen tritt daher wieder in Erscheinung. Für kleine Verstimmungen, wie sie durch die Anwesenheit von magnetischer Tinte gegeben sind, steigt dabei der Wert der Amplitude $U_n$ der Oberwelle annähernd linear an.

In einer ersten Gruppe von Varianten der erfindungsgemässen Anordnung ist die durch die Anordnung 8 ausgewertete Oberwelle eine geradzahlige Oberwelle der Ausgangsspannung u[t] des Sensors 1. Um in diesem Fall eine maximale Empfindlichkeit der Anordnung zu erhalten, sollte zusätzlich zum Erregermagnetfeld H[t] ein konstantes Magnetfeld $H_o$, z.B. eines Permanentmagneten, vorhanden sein zur Maximierung des Wertes der Amplitude $U_n$ der betreffenden geradzahligen Oberwelle. Statt des Permanentmagneten wird im Betrieb bei der Auswertung geradzahliger Oberwellen die erste Spule 4 vorzugsweise, zusätzlich zum periodischen zeitvariablen Erregerstrom i[t], von einem Gleichstom $I_o$ durchflossen, der das konstante Magnetfeld $H_o$ erzeugt. Die Amplitude $U_n$ der geradzahligen Oberwelle ist maximal, wenn der zweite Sinusfaktor in der Gleichung (1) einen Wert von annähernd Eins aufweist. Ein n-facher Wert des konstanten Magnetfeldes $H_o$ sollte daher zur Maximierung des Wertes der Amplitude $U_n$ der geradzahligen Oberwelle vorzugsweise gleich einem ungeraden ganzen Vielfachen der Amplitude $H_{max}$ des Erregermagnetfeldes H[t], d. h. gleich $(2k+1).H_{max}$ sein.

Da bekanntlich eine Sinusfunktion in der Nähe ihres Maximums relativ flach verläuft, ist der Sensor 1 relativ unempfindlich gegenüber Änderungen von äusseren Magnetfeldern und gegenüber die Anwesenheit von Störmagnetfeldern, wie z. B. dem Erdmagnetfeld, was eine Ausführung des Sensors 1 ohne magnetische Abschirmung gestattet. Dies ist insofern möglich, da der Sensor 1 kein Magnetfeld, sondern auf dem Umweg über die Amplitude $U_n$ einer Oberwelle nur die effektive relative Permeabilität $\mu_r{}^*$ des Magnetkreises 2;3 ermittelt.

Zur Vermeidung von Hochfrequenzproblemen und/oder von Hochfrequenzverlusten, wie z. B. einer starken Bedämfung, hoher Wirbelstromverluste, usw., ist die der Auswertung dienende Oberwelle vorzugsweise eine relativ niederfrequente Oberwelle und im Falle einer geradzahligen Oberwelle vorzugsweise die vierte Oberwelle der Ausgangsspannung u[t] des Sensors 1.

Die Amplitude der vierten Oberwelle ist gleich:

$$U_4 = (4/\pi).\mu_o.\mu_r{}^*.n_2.f_1.F.H_{max}.\sin(2\pi H_s/H_{max}).\sin(2\pi H_o/H_{max}) \qquad (2).$$

Zur Auswertung der vierten Oberwelle ist die Amplitude $H_{max}$ des Erregermagnetfeldes H[t] vorzugsweise doppelt so gross wie das Sättigungsmagnetfeld $H_s$ des Magnetkreises 2;3, d. h. wenn $H_{max} = 2.H_s$ gewählt wird, dann ist der erste Sinusfaktor in der Gleichung (2) gleich Null. Das konstante Magnetfeld $H_o$ sollte in diesem Fall vorzugsweise einen Wert von $H_{max}/4$ besitzen, d. h. gleich einem Viertel der Amplitude $H_{max}$ des periodischen zeitvariablen Erregermagnetfeldes H[t] sein.

In einer zweiten Gruppe von Varianten der erfindungsgemässen Anordnung ist die durch die Anordnung 8 ausgewertete Oberwelle eine ungeradzahlige Oberwelle der Ausgangsspannung u[t] des Sensors 1. Aus den gleichen Gründen wie bei der Auswertung geradzahliger Oberwellen ist die der Auswertung dienende Oberwelle wieder vorzugsweise eine relativ niederfrequente Oberwelle und im Falle einer ungeradzahligen Oberwelle vorzugsweise die dritte Oberwelle der Ausgangsspannung u[t] des Sensors 1.

Die Amplitude der dritten Oberwelle ist gleich

$$U_3 = (16/3\pi).\mu_o.\mu_r{}^*.n_2.f_1.F.H_{max}.\sin(3\pi H_s/2H_{max}).\cos(3\pi H_o/2H_{max}) \qquad (3)$$

Zur Auswertung der dritten Oberwelle ist die Amplitude $H_{max}$ des Erregermagnetfeldes H[t] vorzugsweise anderthalb mal so gross wie das Sättigungsmagnetfeld $H_s$ des Magnetkreises 2;3, d. h. wenn $H_{max} = 1,5.H_s$ gewählt wird, dann ist der erste Sinusfaktor in der Gleichung (3) gleich Null. Die Verwendung der dritten Oberwelle hat somit gegenüber der Verwendung der vierten Oberwelle den Vorteil, dass eine kleinere Amplitude $H_{max}$ des periodischen zeitvariablen Erregermagnetfeldes H[t] erforderlich ist zwecks Annulierung der Oberwellenamplitude bei abwesender magnetischer Substanz.

Um bei ungeradzahligen Oberwellen eine maximale Empfindlichkeit der Anordnung zu erhalten, sollte zusätzlich zum Erregermagnetfeld H[t] kein konstantes Magnetfeld $H_o$ vorhanden sein zur Maximierung des Wertes der Amplitude $U_n$ der betreffenden ungeradzahligen Oberwelle, da bei ungeradzahligen Oberwellen der zweite Sinusfaktor der Gleichung (1) immer ein Cosinusfaktor ist [siehe z. B. Gleichung (3)]. Der letztere ist immer gleich Eins, wenn $H_o = O$. Die zweite Gruppe von Varianten hat somit den Vorteil, dass der Wert der Amplitude $U_n$ der ungeradzahligen Oberwelle immer maximal ist, wenn kein konstantes Magnetfeld $H_o$ vorhanden ist. Die Cosinusfunktion ist in der Nähe ihres Maximums genau so unempfindlich gegenüber äusseren Magnetfeldern wie die Sinusfunktion.

In beiden Gruppen von Varianten ist der Sensor 1 jeweils nicht ein Sensor zur Messung eines Magnetfeldes, sondern ein Sensor zur Messung der effektiven relativen Permeabilität $\mu_r{}^*$ des Magnetkreises 2;3, innerhalb dessen Luftspalt 2 sich die magnetische Substanz befindet.

Der Spitzenwert $U_4$ der vierten Oberwelle hat z. B. einen Wert in der Grössenordnung von $10\mu V$, wenn eine Dollarnote einen Abstand von 1 mm zum Sensor 1 aufweist. Die Frequenz des periodischen zeitvariablen Erregerstromes i[t] ist vorzugsweise 20 bis 200 kHz und die Messspule 5 weist z. B. 100 Windungen auf.

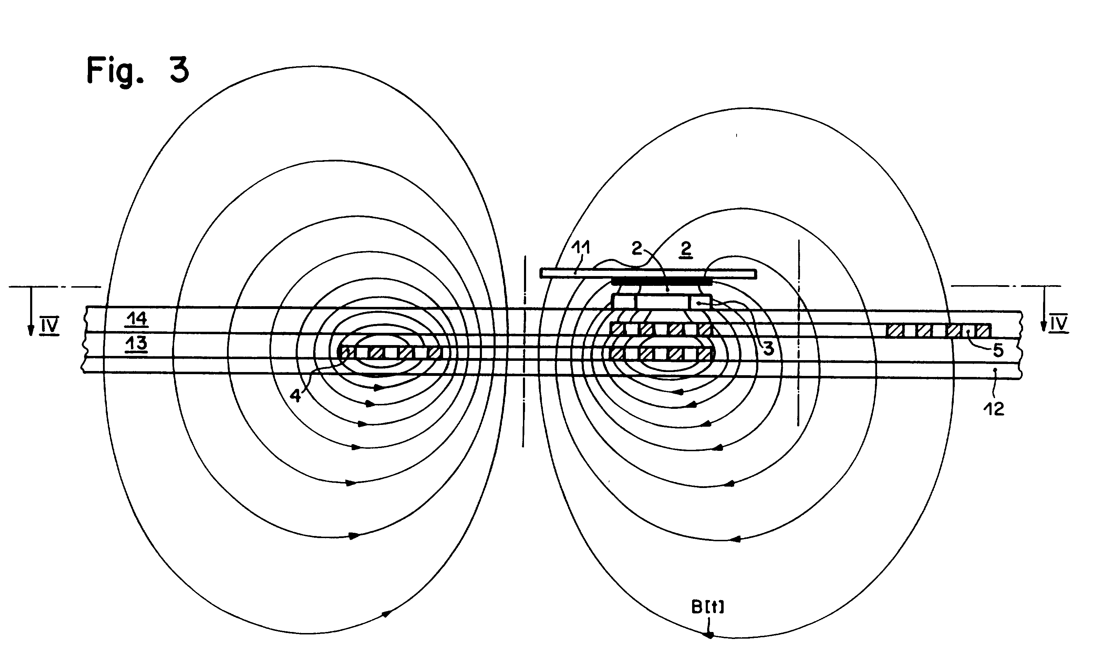

In der Fig. 3 ist die magnetische Tinte schematisch in Gestalt eines kleinen Rechteckes an der Unterseite der Banknote 11 dargestellt.

Der Sensor 1 ist vorzugsweise ein planarer flacher Sensor und besitzt dann in einer bevorzugten Ausführung den in der Fig. 3 und der Fig. 4 dargestellten Aufbau.

Die beiden Spulen 4 und 5 sind in diesem Fall vorzugsweise jeweils Einschichtspulen, die durch eine erste Isolierschicht 13 elektrisch gegeneinander isoliert in zwei getrennten und parallelen Schichten auf einem Trägermaterial, z. B. einem Substrat 12 angeordnet sind. Das Substrat besteht z. B. aus Keramik oder einem anderen billigen und isolierenden Material.

Die beiden Einschichtspulen 4 und 5 sind dabei bevorzugt rechteckspiralförmig und in ihrer jeweiligen Schicht jeweils so angeordnet, dass ein aus geraden und parallelen Leitern bestehendes Viertel der beiden Einschichtspulen 4 und 5 sich mindestens teilweise decken.

Der ferromagnetische Kern 3 ist dünn und weist eine annähernd konstante Dicke auf. Er ist durch eine zweite Isolierschicht 14 elektrisch isoliert in einer parallelen dritten Schicht auf derjenigen der beiden Schichten angeordnet, die die Einschichtspule 5 enthält. Der Kern 3 ist dabei mindestens teilweise deckend oberhalb des sich deckenden Teils der beiden Spulen 4 und 5 angeordnet. In den Figuren 3 und 4 ist die Spule 4 in einer ersten Schicht auf das Substrat 12 aufgetragen, während die Messspule 5 ihrerseits in einer zweiten Schicht auf die erste Isolierschicht 13 aufgetragen ist. Der Kern 3 ist in einer dritten Schicht auf die zweite Isolierschicht 14 aufgetragen. Der Luftspalt 2 des Magnetkreises 2;3 ist gebildet durch den ausserhalb des ferromagnetischen Kerns 3 zwischen der oberen und der unteren parallelen Fläche desselben gelegenen Raum.

In einer ersten Untervariante, die in der Fig. 4 dargestellt ist, besitzt der ferromagnetische Kern 3 eine H-förmige Draufsicht.

In einer zweiten Untervariante, die in der Fig. 5 dargestellt ist, besitzt der ferromagnetische Kern 3 in der Draufsicht die Gestalt einer rechteckförmigen Acht, deren oberer und unterer Querbalken je einen weiteren Luftspalt 15 bzw. 16 aufweist. Wenn eine Banknote an den Luftspalten 15 und 16 vorbeigeführt wird, bilden die beiden letzteren je einen Leseluftspalt zum Lesen des Informationsinhaltes je einer von zwei Spuren magnetischen Materials, welches auf der Banknote aufgetragen ist. Der Luftspalt 2 dient dagegen der Detektion der Anwesenheit des magnetischen Materials auf der Banknote.

Die H-förmige oder achtförmige Gestalt des Kerns 3 dient der Flusskonzentration. Eine möglichst starke Einschnürung in der Mitte des Kerns 3, d. h. ein möglichst schmaler mittlerer Quersteg des H-förmigen oder achtförmigen Kerns 3, ist anzustreben, um einen möglichst niedrigen Entmagnetisierungsfaktor N zu erzielen. Die Breite des mittleren Querstegs beträgt z. B. 0,5 mm und seine Länge z. B. 4 mm. Aus demselben Grund ist auch eine möglichst kleine Kerndicke t zu erstreben, was besonders gut erreichbar ist, wenn der Sensor in einer planaren Mikrotechnologie hergestellt wird. Der Kern 3 besitzt vorzugsweise eine minimale Kerndicke t von annähernd 0,025 mm in einer Hybridtechnologie bzw. 0,5 µm in einer planaren Mikrotechnologie. Das Material des ferromagnetischen Kerns 3 besteht vorzugsweise aus magnetisch amorphem Metall, welches im englischen Sprachgebiet als Magnetglas bezeichnet wird. Die Breite der Hauptstege des H-förmigen Kerns 3 ist z. B. jeweils 5 mm, während ihre Länge z. B. jeweils 40 bis 60 mm beträgt zwecks Überdeckung eines Grossteils der Breite einer Banknote. Trotz Verwendung eines einzigen Messkopfes, wird somit dadurch fast die ganze Breite, mindestens aber 1/4 bis 1/3 der Breite der Banknote erfasst.

Der Entmagnetisierungsfaktor N eines planaren Sensors ist im Wesentlichen gegeben durch das Verhältnis t/L der Kerndicke t zur Kernlänge L des mittleren Querstegs des H-förmigen oder achtförmigen Kerns 3. Die Veränderung des Entmagnetisierungsfaktors N mittels einer Banknote kann somit erfolgen entweder durch eine Änderung der Kernlänge L oder der Kerndicke t. Dank des extrem dünnen Kerns 3, reagiert der Entmagnetisierungsfaktor N und damit auch der Sensor 1 viel empfindlicher auf Änderung seiner Kerndicke t als auf Änderung seiner Kernlänge L, was ersteres durch ein Auflegen der Banknote 11 auf den Kern 3 erreicht wird. Dazu darf der Kern 3 aber nicht mit der Spule 4 umwunden sein, was seiner Funktion nach einer Längsänderung des Kerns 3 entsprechen würde. Die in den Figuren 3 und 4 dargestellte Einschichtspule 4 erfüllt diese Bedingung. In den bevorzugten Ausführungen ist somit die Kerndicke t des ferromagnetischen Kerns 3 durch die magnetische Substanz veränderbar.

Da der Sensor 1 als Flachsensor ausgebildet ist, ist sein Raumbedarf sehr klein. Er arbeitet praktisch "offset"-frei, d. h. seine Nullspannung ist praktisch gleich Null. Rauschen ist praktisch ebenfalls nicht vorhanden, da hauptsächlich nur das bekanntlich extrem schwache Barkhausen-Rauschen des Kerns 3 vorhanden ist. Die Ausgangsspannung u[t] des Sensors 1 ist unabhängig von einer relativen Geschwindigkeit zwischen der magnetischen Substanz und dem Sensor: Eine statische Messung ist somit möglich.

Bei der Verwendung des achtförmigen Kerns 3 ist nicht nur eine Detektion der Anwesenheit, sondern auch ein Lesen der Gestalt der magnetischen Substanz möglich, da die beiden äusseren Querstege des achtförmigen Kerns 3 zwei Zeilen der Banknote lesen können, so dass der Wert der Banknote mit grosser Sicherheit ermittelt werden kann.

**Patentansprüche**

1. Vorrichtung zum Nachweis einer magnetischen Substanz nach dem Kernsättigungsprinzip, aufweisend:

   einen Sensor (1) mit einem Magnetkreis (2, 3), der von einem Sättigungsmagnetfeld ($H_s$) gesättigt werden kann, und einer Erregerspule (4) sowie einer Meßspule (5), die beide an den Magnetkreis (2, 3) magnetisch gekoppelt sind,
   eine an die Erregerspule (4) gekoppelte Einrichtung (6) zur periodischen Aussteuerung des Magnetkreises (2, 3) in die Sättigung mit einem Erregermagnetfeld (H[t]), dessen Amplitude ($H_{max}$) größer als der Wert des Sättigungsmagnetfelds ($H_s$) ist, und
   eine Auswerteinrichtung (9, 10) zur Auswertung einer Harmonischen einer von dem Erregermagnetfeld (H[t]) in der Meßspule (5) induzierten Spannung (u[t]),

   dadurch gekennzeichnet, daß ein geradzahliges Vielfaches (2k) der genannten Amplitude ($H_{max}$) gleich einem ganzzahligen vielfachen (n) Wert des Sättigungsmagnetfelds ($H_s$) ist, und

   daß die Auswerteinrichtung (9, 10) zur Auswertung der n-ten Harmonischen angeordnet ist, wobei n das genannte ganzzahlige Vielfache darstellt, um eine Änderung in der effektiven relativen Permeabilität des Magnetkreises (2, 3) bei Vorhandensein der magnetischen Substanz in einem Luftspalt (2) des Magnetkreises (2, 3) festzustellen.

2. Vorrichtung nach Anspruch 1, wobei die genannte Harmonische eine geradzahlige Harmonische ist.

3. Vorrichtung nach Anspruch 2, mit einer Einrichtung zur Erzeugung eines konstanten Magnetfelds mit einer Amplitude, die gleich einem ungeradzahligen Vielfachen (2k+1) der Amplitude ($H_{max}$) des Erregermagnetfelds (H[t]) dividiert durch die Nummer n der Harmonischen ist, um die Amplitude der geradzahligen Harmonischen zu maximieren.

4. Vorrichtung nach Anspruch 3, wobei die Einrichtung zur Erzeugung eines konstanten Magnetfelds zur Erzeugung eines Gleichstroms durch die Erregerspule (4) eingerichtet ist.

5. Vorrichtung nach Anspruch 3 oder 4, wobei die geradzahlige Harmonische die vierte Harmonische der in der Meßspule (5) induzierten Spannung (u[t]) ist.

6. Vorrichtung nach Anspruch 5, wobei die Amplitude ($H_{max}$) des Erregermagnetfelds (H[t]) doppelt so groß wie die Amplitude des Sättigungsmagnetfelds ($H_s$) des Magnetkreises (2, 3) ist.

7. Vorrichtung nach Anspruch 5 oder 6, wobei die Größe des konstanten Magnetfelds ein Viertel der Amplitude ($H_{max}$) des Erregermagnetfelds (H[t]) ist.

8. Vorrichtung nach Anspruch 1, wobei die Harmonische eine ungeradzahlige Harmonische ist.

9. Vorrichtung nach Anspruch 8, wobei der Magnetkreis (2, 3) von einem konstanten Magnetfeld frei ist.

10. Vorrichtung nach Anspruch 9, wobei die ungeradzahlige Harmonische die dritte Harmonische der in der Meßspule (5) induzierten Spannung (u[t]) ist.

11. Vorrichtung nach Anspruch 10, wobei die Amplitude ($H_{max}$) des Erregermagnetfelds (H[t]) anderthalb mal so groß wie das Sättigungsmagnetfeld ($H_s$) des Magnetkreises (2, 3) ist.

12. Vorrichtung nach einem der vorhergehenden Ansprüche, wobei der Sensor (1) eine planare, flache Geometrie aufweist.

13. Vorrichtung nach Anspruch 12, wobei der Magnetkreis (2, 3) einen ferromagnetischen Kern (3) mit einer von der magnetischen Substanz veränderbaren Dicke enthält.

14. Vorrichtung nach Anspruch 12 oder 13, wobei die Erregerspule (4) und die Meßspule (5) jeweils Einschichtspulen sind, die elektrisch gegeneinander isoliert in zwei getrennten parallelen Schichten angeordnet sind.

**15.** Vorrichtung nach Anspruch 14, wobei die Erregerspule (4) und die Meßspule (5) jeweils rechteck-spiralförmig und so angeordnet sind, daß sich parallele Leiter einer Seite der Erregerspule (4) und parallele Leiter einer Seite der Meßspule (5) überlappen.

**16.** Vorrichtung nach Anspruch 15, wenn abhängig von Anspruch 13, wobei der ferromagnetische Kern (3) dünn ist, eine etwa konstante Dicke aufweist und elektrisch isoliert in einer zu den Schichten der Erreger- und der Meßspule (4, 5) parallelen Schicht bei mindestens teilweiser Überlappung mit dem Überlappbereich der Erreger- und der Meßspule (4, 5) angeordnet ist, wobei der Luftspalt (2) den außerhalb der oberen und der unteren parallelen Fläche des ferromagnetischen Kerns (3) gelegenen Raum umfaßt.

**17.** Vorrichtung nach Anspruch 16, wobei der ferromagnetische Kern (3) in Draufsicht H-förmig ist.

**18.** Vorrichtung nach Anspruch 16, wobei der ferromagnetische Kern (3) in Draufsicht die Gestalt einer rechteckförmigen Acht aufweist, deren obere und untere Querbalken je einen weiteren Luftspalt (15, 16) aufweisen.

## Claims

**1.** An apparatus for detecting a magnetic substance according to the core saturation principle, comprising:

a sensor (1) having a magnetic circuit (2, 3) that can be saturated by a saturation magnetic field ($H_s$), and an exciting coil (4) and a measuring coil (5) both of which are magnetically coupled to the magnetic circuit (2, 3), a device (6), coupled to the exciting coil (4), for periodically driving the magnetic circuit (2, 3) into saturation with an exciting magnetic field (H[t]) the amplitude ($H_{max}$) of which is greater than the value of the saturation magnetic field ($H_s$), and
an evaluating device (9, 10) for evaluating a harmonic of a voltage (u[t]) induced in the measuring coil (5) by the exciting magnetic field (H[t]),

characterised in that an even-numbered multiple (2k) of said amplitude ($H_{max}$) is equal to an integral multiple (n) value of the saturation magnetic field ($H_s$), and

the evaluating device (9, 10) is arranged to evaluate the n-th harmonic, where n represents said integral multiple, in order to detect a change in the effective relative permeability of the magnetic circuit (2, 3) when the magnetic substance is present in an air gap (2) of the magnetic circuit (2, 3).

**2.** An apparatus according to claim 1, wherein said harmonic is an even-numbered harmonic.

**3.** An apparatus according to claim 2, comprising a device for producing a constant magnetic field of an amplitude equal to an odd-numbered multiple (2k+1) of the amplitude ($H_{max}$) of the exciting magnetic field (H[t]) divided by the number n of the harmonic in order to maximise the amplitude of the even-numbered harmonic.

**4.** An apparatus according to claim 3, wherein the device for producing a constant magnetic field is operable to produce a direct current through the exciting coil (4).

**5.** An apparatus according to claim 3 or 4, wherein the even-numbered harmonic is the fourth harmonic of the vohage (u[t]) induced in the measuring coil (5).

**6.** An apparatus according to claim 5, wherein the amplitude ($H_{max}$) of the exciting magnetic field (H[t]) is double the amplitude of the saturation magnetic field ($H_s$) of the magnetic circuit (2, 3).

**7.** An apparatus according to claim 5 or 6, wherein the magnitude of the constant magnetic field is a quarter ofthe amplitude ($H_{max}$) of the exciting magnetic field (H[t]).

**8.** An apparatus according to claim 1, wherein the harmonic is an odd-numbered harmonic.

**9.** An apparatus according to claim 8, wherein the magnetic circuit (2, 3) is free from a constant magnetic field.

**10.** An apparatus according to claim 9, wherein the odd-numbered harmonic is the third harmonic of the voltage (u[t]) induced in the measuring coil (5).

11. An apparatus according to claim 10, wherein the amplitude ($H_{max}$) of the exciting magnetic field (H[t]) is one and a half times the saturation magnetic field ($H_s$) of the magnetic circuit (2, 3).

12. An apparatus according to any one of the preceding claims, wherein the sensor (1) has a planar, flat geometry.

13. An apparatus according to claim 12, wherein the magnetic circuit (2, 3) contains a ferromagnetic core (3) having a thickness that can be altered by the magnetic substance.

14. A sensor for an apparatus according to claim 12 or 13, wherein the exciting coil (4) and the measuring coil (5) are each single-layer coils arranged electrically insulated from each other in two separate parallel layers.

15. A sensor according to claim 14, wherein the exciting coil (4) and the measuring coil (5) are each rectangularly spiral and so arranged that parallel conductors of one side of the exciting coil (4) and parallel conductors of one side of the measuring coil (5) overlap.

16. A sensor according to claim 15 when dependent on claim 13, wherein the ferromagnetic core (3) is thin, has approximately constant thickness and is arranged electrically insulated in a layer parallel to the layers of the exciting and measuring coils (4, 5) and at least partially overlapping the region of overlap of the exciting and measuring coils (4, 5), the air gap (2) comprising the space located outside the upper and the lower parallel surface of the ferromagnetic core (3).

17. A sensor according to claim 16, wherein the ferromagnetic core (3) is H-shaped in plan view.

18. A sensor according to claim 16, wherein the ferromagnetic core (3) has in plan view the shape of a rectangular eight the upper and lower cross-pieces of which each have a further air gap (15, 16).

**Revendications**

1. Dispositif pour détecter une substance magnétique selon le principe de saturation du noyau, présentant:

   ■ un détecteur (1) comportant un circuit magnétique (2, 3) qui peut être saturé par un champ magnétique de saturation ($H_s$) ainsi qu'une bobine d'excitation (4) et qu'une bobine de mesure (5) qui sont l'une et l'autre magnétiquement couplées au circuit magnétique (2, 3),

   ■ un dispositif (6), couplé à la bobine d'excitation (4), pour mettre périodiquement en saturation le circuit magnétique (2, 3) au moyen d'un champ magnétique d'excitation (H[t]), dont l'amplitude ($H_{max}$) est supérieure à la valeur du champ magnétique de saturation ($H_s$), et

   ■ un dispositif de traitement (9, 10) pour traiter un harmonique d'une tension (U[t]) induite par le champ magnétique d'excitation (H[t]) dans la bobine de mesure (5),

   caractérisé par le fait qu'un multiple pair (2k) de l'amplitude mentionnée ($H_{max}$) est égal à un multiple entier (n) de la valeur du champ magnétique de saturation ($H_s$), et

   ■ que le dispositif de traitement (9, 10) est disposé pour le traitement de l'harmonique d'ordre n, n représentant le multiple entier mentionné, pour déterminer une modification de la perméabilité relative efficace du circuit magnétique (2, 3) en présence de la substance magnétique dans un entrefer (2) du circuit magnétique (2, 3).

2. Dispositif selon la revendication 1, dans lequel l'harmonique mentionné est un harmonique d'ordre pair.

3. Dispositif selon la revendication 2, comportant un dispositif pour produire un champ magnétique constant dont l'amplitude est égale à un multiple impair (2k+1) de l'amplitude (Hmax) du champ magnétique d'excitation (H[t]) divisé par le nombre n des harmoniques, pour rendre maximale l'amplitude de l'harmonique pair.

4. Dispositif selon la revendication 3, dans lequel le dispositif prévu pour produire un champ magnétique constant est réglé pour produire un courant continu dans la bobine d'excitation (4).

5. Dispositif selon la revendication 3 ou 4, dans lequel l'harmonique d'ordre pair est le quatrième harmonique de la tension (u[t]) induite dans la bobine de mesure (5).

6. Dispositif selon la revendication 5, dans lequel l'amplitude ($H_{max}$) du champ magnétique d'excitation (H[t]) est deux fois plus grande que l'amplitude du champ magnétique de saturation ($H_s$) du circuit magnétique (2, 3).

7. Dispositif selon la revendication 5 ou 6, dans lequel la grandeur du champ magnétique constant est un quart de l'amplitude (($H_{max}$) du champ magnétique d'excitation (H[t]).

8. Dispositif selon la revendication 1, dans lequel l'harmonique est un harmonique d'ordre impair.

9. Dispositif selon la revendication 8, dans lequel le circuit magnétique (2, 3) est exempt d'un champ magnétique constant.

10. Dispositif selon la revendication 9, dans lequel l'harmonique d'ordre impair est le troisième harmonique de la tension (u[t]) induite dans la bobine de mesure (5).

11. Dispositif selon la revendication 10, dans lequel l'amplitude ($H_{max}$) du champ magnétique d'excitation (H[t]) est une fois et demie plus grande que le champ magnétique de saturation ($H_s$) du circuit magnétique (2, 3).

12. Dispositif selon l'une des revendications précédentes, dans lequel le détecteur (1) présente une géométrie plane.

13. Dispositif selon la revendication 12, dans lequel le circuit magnétique (2, 3) contient un noyau ferromagnétique (3) d'une épaisseur variable selon la substance magnétique.

14. Détecteur pour un dispositif selon la revendication 12 ou 13, dans lequel la bobine d'excitation (4) et la bobine de mesure (5) sont chacune des bobines monocouches qui sont disposées, électriquement isolées l'une de l'autre, dans deux couches parallèles distinctes.

15. Détecteur selon la revendication 14, dans lequel la bobine d'excitation (4) et la bobine de mesure (5) sont chacune disposées sous forme de spirale rectangulaire et de façon que des lignes parallèles d'un côté de la bobine d'excitation (4) et des lignes parallèles d'un côté de la bobine de mesure (5) se recouvrent.

16. Détecteur selon la revendication 15, lorsqu'elle dépend de la revendication 13, dans lequel le noyau ferromagnétique (3) est mince, présente une épaisseur à peu près constante et est disposé, électriquement isolé, dans une couche parallèle aux couches de la bobine d'excitation et de la bobine de mesure (4, 5), en recouvrement au moins partiel avec la zone de recouvrement de la bobine d'excitation et de la bobine de mesure (4, 5), l'entrefer (2) comprenant l'espace existant à l'extérieur de la surface supérieure et de la surface parallèle inférieure du noyau ferromagnétique (3).

17. Détecteur selon la revendication 16, dans lequel le noyau ferromagnétique (3) a, en vue de dessus, la forme d'un H.

18. Détecteur selon la revendication 16, dans lequel le noyau ferromagnétique (3) présente, en vue de dessus, la forme d'un huit rectangulaire dont les demi-branches supérieures et inférieures présentent, chacune, leur propre entrefer (15, 16).

**Fig. 1**

**Fig. 2**

**Fig. 5**

Fig. 3

Fig. 4